# EUROPEAN PATENT APPLICATION

(11) **EP 1 101 629 A2**
(43) Date of publication of application: **23.05.2001**
(21) Application number: 00125143.8
(22) Date of filing: 17.11.2000
(51) Int. Cl.: B41N 3/03

(54) **Method of fabricating a photopolymer type light-sensitive planographic printing plate**

(30) Priority: 19.11.1999 JP 32931799
(71) Applicant: FUJI PHOTO FILM CO., LTD., Kanagawa-ken (JP)
(72) Inventor: Sasaki, Hidehito, Fuji Photo Film Co., Ltd., Haibara-gun, Shizuoka-ken (JP)
(74) Representative: Grünecker, Kinkeldey, Stockmair & Schwanhäusser Anwaltssozietät

(57) **Abstract**

A method of fabricating a photopolymer type light-sensitive planographic printing plate, wherein a time from completion of an anodizing treatment process to commencement of a photopolymeric light-sensitive layer coating process is controlled so as to control adhesion that acts between a support and a photopolymeric light-sensitive layer of the photopolymer type light-sensitive planographic printing plate.

## Description

### BACKGROUND OF THE INVENTION

### Field of the Invention

The present invention relates to a method of fabricating a photopolymer type light-sensitive planographic printing plate such as a photopolymer type digital printing plate having a photopolymer type photopolymeric light-sensitive layer.

### Description of the Related Art

There are known various light-sensitive layers for negative-type planographic printing plates; for example, a diazo resin-containing layer, a photopolymerization layer, a light cross-linking layer and the like. In order to prepare such planographic printing plates, generally, there has been provided a method in which a clear negative film original (lith film) is placed on each planographic printing plate and an image exposed using ultraviolet radiation. Therefore, much labor has been required to carry out operations.

Along with the recent remarkable progress of image forming technology, there have been earnest demands for a photopolymer which has high light sensitivity with respect to light in a visible region and which is suitable, for example, for non-contact type projection/exposure plate-making, visible light laser plate-making, and the like. As a light-sensitive material which can respond to such demands, a photopolymeric light-sensitive material has the highest light sensitivity. Examples of visible laser light include Ar laser light (488 or 514.5 nm), second harmonic light of a semiconductor laser (SHG-LD: 350 to 600 nm), and SHG-YAG laser light (532 nm).

Thus, by using a certain type of high sensitivity photopolymeric light-sensitive layer, laser light whose beam diameter has been stopped down finely is scanned on a plate surface, and a character original, an image original, or the like is directly formed on the plate surface. Thus, a direct plate-making without using a film original is made possible. For example, light-sensitive compositions disclosed in Japanese Patent Application Publication (JP-B) No. 61-9621, Japanese Patent Application Laid-Open (JP-A) Nos. 63-178105 and 2-244050, and the like can be used to carry out direct plate-making without using a film original.

However, in one of these conventional high sensitivity photopolymeric printing plates, adhesion between a light-sensitive layer and a support is not necessarily strong. Consequently, when this high sensitivity photopolymeric printing plate is used for highspeed massive printing, there are discrepancies in that solid images are cut off, and narrow lines or highlight portions are reduced or discontinuous.

Accordingly, with a high sensitivity photopolymer, since adhesion between the support and the light-sensitive layer is an important factor, numerous studies have been conducted to develop the adhesion.

For example, JP-A Nos. 3-56177, 7-159838, 8-320551 and the like disclose inventions in which, in order to increase adhesion between a support and a photopolymeric light-sensitive layer due to covalent bonding, functional groups which may cause addition reactions by radicals are provided on the surface of the support. Although adhesion has certainly been increased by these inventions, the degree of adhesion is not satisfactory in practice, and it is therefore desired to further increase adhesion.

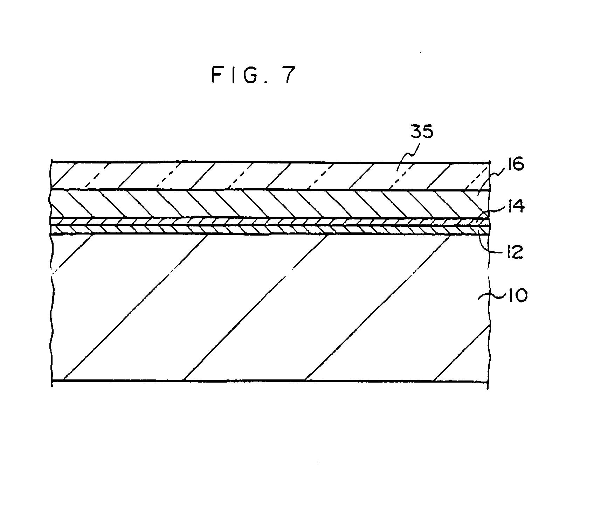

For this reason, as shown in Fig. 7, adhesion between a support 10 and a photopolymeric light-sensitive layer 16 has been secured as described below. An anodizing treatment is applied to the aluminum support 10 such that an anodizing coating (which is referred to as an "AD layer 12" hereinafter) is formed on the support 10. An undercoating layer (which is referred to as an "intermediate layer 14" hereinafter) is provided on the support 10. Then, the photopolymeric light-sensitive layer 16 is formed on the intermediate layer 14. Further, an OC layer (oxygen isolating protective layer) 35 is provided on the photopolymeric light-sensitive layer 16.

Incidentally, the anodizing treatment was originally applied in order to enhance the resistance of a non-image portion (a portion of the support 10 at which the photopolymeric light-sensitive layer is removed after exposure of an image) and to increase printing durability of the support 10. However, immediately after the application of the anodizing treatment, the AD layer forms an absorption site which absorbs water or inorganic or organic matter suspended in the air. Thus, the AD layer has extremely strong absorbency with respect to various substances.

However, conventionally, adhesion between a support and a photopolymeric light-sensitive layer has been increased by providing an intermediate layer between the support and the photopolymeric light-sensitive layer. As a result, little attention has been paid to the absorbency of the absorption site.

### SUMMARY OF THE INVENTION

Noting that an absorption site of an AD layer has strong absorbency, an object of the present invention is to provide a method of fabricating a photopolymer type light-sensitive planographic printing plate which can improve adhesion between a support and a photopolymeric light-sensitive layer.

In the present invention, adhesion between the support and the photopolymeric light-sensitive layer of the photopolymer type light-sensitive planographic printing plate is adjusted by controlling the time between completion of an anodizing treatment process and commencement of a photopolymeric light-sensitive layer coating process.

With regard to the absorption site of the AD layer, which absorption site is formed by the anodizing treatment and has strong absorbency, the time from the completion of the anodizing treatment process to the start of the photopolymeric light-sensitive layer coating process is controlled. Thus, the absorption site absorbs matter suspended in the air or the like, and an optimum amount of coating on the absorption site (or, conversely speaking, an optimum effective absorption area of the absorption site) is thereby obtained.

The optimum conditions are defined by considering amounts of light when laser light an image onto the printing plate. Further, after exposure and a development treatment of the image have been completed, the optimum conditions can realize adhesion such that a portion of the photopolymeric light-sensitive layer that is, intended to be stripped off can be stripped off from the support while a portion thereof that is, intended to remain adhered remains adhered to the support. That is, if the absorption site on the support is in a non-coated state, adhesion will be excessive, thus making it difficult to strip off from the support the portion of the photopolymeric light-sensitive layer that is intended to be stripped off. As a result, a problem arises in that stains or the like occur on prints.

Further, the present invention discloses that a time between completion of the anodizing treatment process and commencement of the photopolymeric light-sensitive layer coating process is not more than 10 minutes. Because the timing is set in this way, sufficient adhesion to prevent the photopolymeric light-sensitive layer from being stripped off from the support after the development treatment can be obtained even with a high light-sensitivity photopolymeric light-sensitive layer. That is, sufficient adhesion can be obtained even where light amounts are small and the photopolymeric light-sensitive layer does not become thoroughly polymerized.

Moreover, the present invention discloses that, in a silicate treatment process which is carried out before the photopolymeric light-sensitive layer coating process, an amount of coating onto the absorption site, which was formed on the support during the anodizing treatment process, is controlled. During this silicate treatment process, by changing concentration of an aqueous solution, temperature, impregnating time and the like, optimum conditions of the coating amount of the absorption site in the photopolymeric light-sensitive layer coating process can be obtained.

### BRIEF DESCRIPTION OF THE DRAWINGS

Fig. 1 is an overall view illustrating a method of fabricating a photopolymer type light-sensitive planographic printing plate according to an embodiment of the present invention.

Fig. 2 is an imaginary perspective view illustrating an absorption site of the photopolymer type light-sensitive planographic printing plate according to the present embodiment.

Fig. 3 is a cross-sectional view of the photopolymer type light-sensitive planographic printing plate according to the present embodiment.

Fig. 4 is a schematic cross-sectional view illustrating a cross-section of a photopolymer type light-sensitive planographic printing plate according to the present embodiment which has been subjected to development treatment.

Fig. 5 is a graph illustrating a relationship between adhesion of an absorption site and time for which the absorption site is left to stand.

Fig. 6 is a table showing results of measurement of GS sensitivity.

Fig. 7 is a cross-sectional view illustrating a conventional photopolymer type light-sensitive planographic printing plate.

### DESCRIPTION OF THE PREFERRED EMBODIMENTS

A method of fabricating a photopolymer type light-sensitive planographic printing plate according to an embodiment of the present invention will be explained below with reference to the drawings.

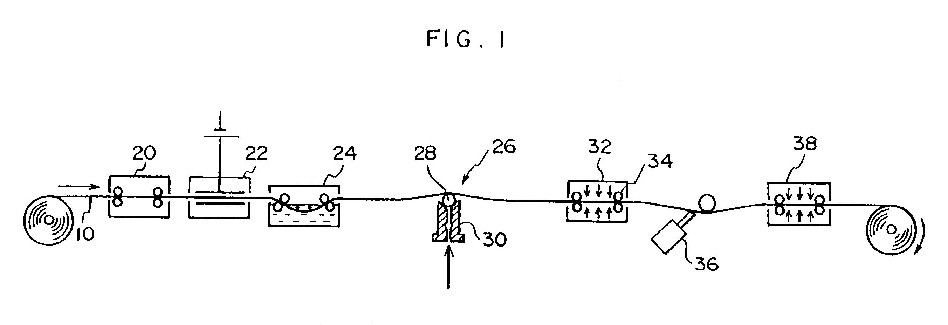

As shown in Fig. 1, an aluminum support 10, which is used in the embodiment of the present invention and which is taken up in a roll, has a thickness of about 0.1 mm to 0.6 mm and is selected in accordance with the type of printer to be used.

### Graining treatment process 20

As a graining treatment method, there are methods such as mechanical graining, chemical etching, electrolytic graining, and the like, as disclosed in Japanese Patent Application Laid-Open (JP-A) No. 56-28893. Further, it is possible to use an electrochemical graining method. In the electrochemical graining method, the surface of the aluminum support is electrochemically grained in a hydrochloric acid or nitric acid electrolytic solution. Examples of mechanical graining method include: a wire brush graining method in which the aluminum support surface is scraped by metal wires; a ball graining method in which the surface is grained using grinding balls and abrasives; and a brush graining method in which the surface is grained using nylon brushes and abrasives. The graining methods described above can be used solely or in combination.

Of these graining methods, to attain a surface roughness that is useful for the present invention, the aforementioned electrochemical graining method, with the surface of the aluminum support being electrochemically grained in a hydrochloric acid or nitric acid electrolytic solution and a suitable current density being 100 C/dm² to 400 C/dm² can be employed. More specifically, it is preferable to perform electrolysis in an electrolytic solution which contains hydrochloric acid or nitric acid in an amount of 0.1 % to 50 % under conditions of a temperature of 20 to 100°C, a duration of 1 sec. to 30 minutes, and a current density of 100 C/dm² to 400 C/dm².

The aluminum support 10 which has been subjected to the graining treatment as described above is chemically etched by an acid or alkali. In a case in which an acid is used as an etchant, it takes time for the acid to destroy microstructure of the support 10, which duration is disadvantageous for application of the present invention in industrial fields. However, this disadvantage can be overcome if an alkali is used as the etchant.

Examples of alkaline agents which are suitably used in the present invention include: caustic soda, sodium carbonate, aluminate soda, metasilicate soda, phosphate soda, potassium hydroxide, lithium hydroxide, and the like. Preferable ranges of density and temperature are 1 to 50 % and 20 to 100°C, respectively. Conditions under which an amount of Al dissolved is 5 to 20 g/m³ are preferable.

Deoxidizing is carried out to remove residual stains (smuts) which remain on the surface after etching. Examples of acids which are used for deoxidizing include: nitric acid, sulfuric acid, phosphoric acid, chromic acid, hydrofluoric acid, borohydrofluoric acid, and the like. In particular, preferable examples of a smut removing processing method to be used after an electrochemical surface roughening treatment has been applied to the aluminum support 10 are a method disclosed in JP-A No. 53-12739, in which the surface of the aluminum support 10 is brought into contact with sulfuric acid having a concentration of 15 to 65 wt% and a temperature of 50 to 90 °C, and a method disclosed in Japanese Patent Application Publication (JP-B) No. 48-28123, in which alkali etching is applied to the surface.

### Anodizing treatment process 22

An anodizing treatment process is further applied to the thus processed aluminum support 10. The anodizing treatment process can be carried out using methods that have conventionally been used in this field. More specifically, an anodizing coating (referred to as an "AD layer 12" hereinafter) can be formed on the surface of the aluminum support 10 by applying direct current or alternating current to the support 10 in an aqueous or non-aqueous solution of sulfuric acid, phosphoric acid, chromic acid, oxalic acid, sulfaminic acid, benzene sulfonic acid or the like in a combination of two or more thereof.

Since conditions of the anodizing treatment process are variously changed in accordance with the electrolytic solution being used, the conditions cannot be defined generally. However, typically, a concentration of the electrolytic solution of 1 to 80 %, a liquid temperature of 5 to 70 °C, a current density of 0.5 to 60 A/dm², a voltage of 1 to 100 V, and an electrolyzing time of 10 to 100 seconds are appropriate.

Among anodizing treatment processes, British Patent No. 1,412,768 discloses a preferable method in which a high density current is applied to the surface of the aluminum support 10 in sulfuric acid such that the surface is anodized and U.S. Patent No. 3,511,661 discloses a preferable method in which a phosphate is used in an electrolytic bath to anodize the surface of the aluminum support 10.

In the present invention, the amount of the AD layer 12 coated onto the surface of the aluminum support 10 is preferably 1 to 10 g/m². If the coating amount of the AD layer 12 is less than 1 g/m², the printing plate will be susceptible to damage. And if the coating amount of the AD layer 12 is more than 10 g/m², an excessive amount of electric power is needed to fabricate the plate and the printing plate of the present invention cannot be fabricated with a satisfactory economic performance. The coating amount of the AD layer 12 is preferably 1.5 to 7 g/m², and more preferably 2 to 5 g/m².

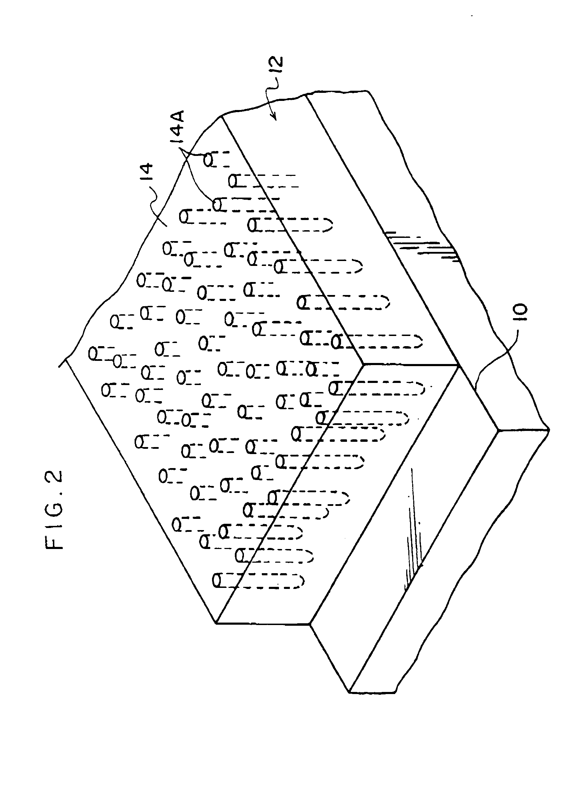

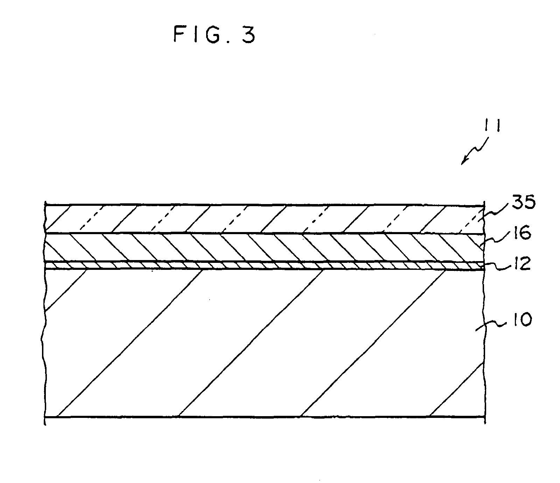

With reference to Figs. 2 and 3, the AD layer 12 will be conceptually explained below. An absorption site 14 of the AD layer 12 is electrically charged. When the thickness of the AD layer 12 is about 1µm, substantially cylindrical holes 14A having inner diameters of about 10 nm are formed at random on the surface of the absorption site 14. A ratio of the total of inner peripheral areas of all the holes 14A to the area of the upper surface of the absorption site 14 is from about 20:1 to about 50:1.

The larger the absorbing area of the absorption site 14 is, including the inner peripheries of the holes 14A, the better adhesion of the absorption site 14 to a photopolymeric light-sensitive layer 16 (which will be described later). However, over time, various substances are absorbed by the absorption site 14, and the degree to which the absorption site 14 is coated becomes excessive.

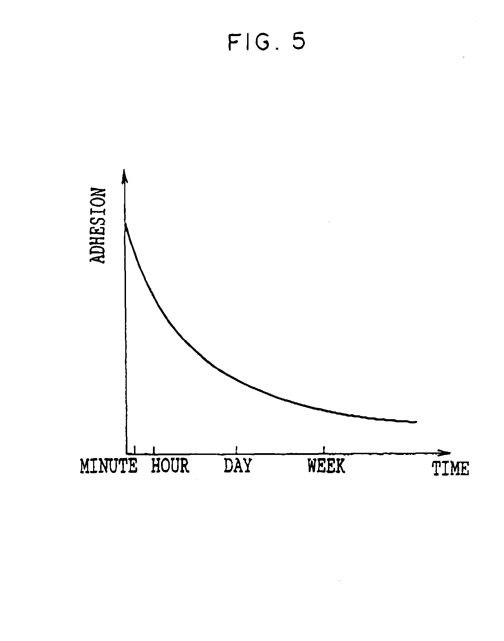

As a result, aluminum water-soluble matters are generated, which results in blockage of openings of the holes 14A, reductions of inner peripheries of the holes 14A, reduction of the absorbing area of the absorption site 14, and a decrease of adhesion of the absorption site 14 to the photopolymeric light-sensitive layer 16. The graph in Fig. 5 illustrates this phenomenon in respect of adhesion. From this graph, it can be understand that the adhesion decreases rapidly for the first few minutes and the rate of decrease gradually slows over hours, days, and weeks.

In the present embodiment, the time from completion of the anodizing treatment process (from the absorption site being formed on the support) to commencement of a main coating process (a process in which the photopolymeric light-sensitive layer is coated) is equal to or less than 10 minutes. This time, "equal to or less than 10 minutes", is a time in which the degree of coating of the absorption site 14 (the absorbing area) becomes optimum, and is determined with regard to amounts of light when the photopolymeric light-sensitive layer 16 is exposed with a laser beam.

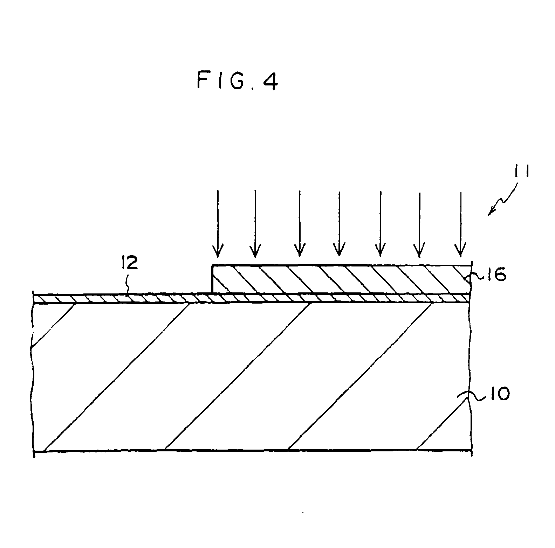

That is, as shown in Fig. 4, adhesion can be provided to the extent that, after exposure of the laser beam onto the photopolymeric light-sensitive layer 16 and development treatment, a non image portion of the photopolymeric light-sensitive layer 16 can be stripped off from the AD layer 12, while an image portion is not stripped off. Here, if the adhesion is excessive, a portion of the non-image portion of the photopolymeric light-sensitive layer 16 will remain, resulting in staining of prints.

### Silicate treatment process 24

After such processes as a graining treatment process and an anodizing treatment process as described above have been appropriately applied to the aluminum support 10, a hydrophilization treatment using silicate can be applied to the surface of the aluminum support 10, as in a method disclosed in JP-A No. 8-41690,. The hydrophilization treatment using silicate is carried out in the present invention in order to form a silicate film. The silicate film is preferably formed with an Si elemental amount of 0.1 to 20 mg/m², and more preferably 0.5 to 10 mg/m². The coating amount of the film can be measured by fluorescent X-ray analysis. Thus, the Si elemental amount can be determined.

As the aforementioned hydrophilization treatment, an example disclosed in JP-B No. 47-5125, in which an aluminum support that has been subjected to an anodizing treatment is immersed in an aqueous alkaline metal silicate solution, can be suitably used. Further, as disclosed in U.S. Patent Nos. 2,714,066, 3,181,461, 3,280,734 and 3,902,734, a method using an alkaline metal silicate (e.g. an aqueous sodium silicate solution) for the hydrophilization treatment can be employed. In accordance with this method, an aluminum support having an anodized coating formed thereon is immersed, for example, at a temperature of 15 to 80°C, for 0.5 to 120 seconds, in a 0.1 to 30 wt%, preferably 0.5 to 15 wt%, aqueous alkaline metal silicate solution which has a pH of 10 to 13 at 25°C.

Because of this silicate treatment, the surface of the absorption site 14 becomes coated in a shorter period of time than in a case in which the silicate treatment is not applied to the surface of the aluminum support 10, in the case. Further, by changing concentration of the aqueous solution, temperature, immersion time and the like, the coating amount of the absorption site 14 can be controlled and the adhesion of the absorption site 14 can be controlled.

### Main coating process

Principal components for forming the photopolymeric light-sensitive layer 16 used in the present invention include: a compound which includes an addition-polymerizable ethylene double bond, a photopolymerization initiator, an organic high polymer coupler and the like, to which components can be added as needed various compounds such as colorants, plasticizers, thermal polymerization inhibitors and the like.

The compound which includes the addition-polymerizable ethylene double bond can be freely selected from compounds at least one, and preferably at least two, terminal ethylenic unsaturated bonds.

Examples of chemical configurations of such compounds include: monomers; pre-polymers, namely, dimers, trimers, and oligomers; mixtures thereof; and copolymers thereof.

Examples of monomers and copolymers thereof include: esters of unsaturated carbonic acids (for example, acrylic acid, methacrylic acid, itaconic acid, crotonic acid, isocrotonic acid, maleic acid, and the like) with fatty polyalcohol compounds; amides of unsaturated carbonic acids with fatty polyamine compounds; and the like.

The photopolymeric light-sensitive layer 16 is formed by a light-sensitive solution coating device 26. The light-sensitive solution coating device 26 has a roll-shaped wire bar 28 which extends in a direction orthogonal to the direction in which the support 10 is transported. The overall length of the wire bar 28 is supported by a supporting block 30 at the center of which a V-shaped groove is formed such that the wire bar 28 is rotatable. Thus, the wire bar 28 is prevented from sagging under its own weight. Further, the light-sensitive solution coating device 26 is structured such that, in accordance with rotation of the wire bar 28, a predetermined amount of a light-sensitive solution is taken out from a reservoir and the light-sensitive solution is applied to the support 10.

### Drying process

The support 10 for which the main coating process has been completed is transported to a drying room 32, heated, dried by a low humidity atmosphere or by blowing of hot air, passed through pass rolls 34, and discharged outside as a product.

### OC layer coating process

An OC layer (oxygen isolating protective layer) 35 is provided on the photopolymeric light-sensitive layer 16. Examples of water soluble vinyl polymers contained in the OC layer 35 include: polyvinyl alcohol and partial esters thereof, ethers and acetals thereof, and copolymers thereof which contain a substantial amount of an unsubstituted vinyl alcoholic unit so as to have the necessary level of water solubility; for example, polyvinyl alcohol which is 71 to 100 % hydrolyzed and has a polymerization degree of 300 to 2400.

Further, as a solvent used when the OC layer 35 is coated onto the light-sensitive layer 16, pure water is preferably used. However, alcohols such as methanol and ethanol and ketones such as acetone and methyl ethyl ketone can be used in combination with pure water. A concentration of solids in the coating solution is suitably 1 to 20 wt%. In a coating device 36, the OC layer 35 is coated, in a slushing manner, onto the photopolymeric light-sensitive layer 16 of the support 10 being transported.

### Final drying process

The support 10 having the OC layer 35 coated thereon is transported to a final drying room 38, in which a drying process is carried out at a predetermined temperature.

Finally, a method of evaluating adhesion of the photopolymeric light-sensitive layer, and results of evaluation, will be explained below.

In the method of evaluating adhesion, adhesion was determined by gray scale (GS) sensitivity. That is, a gray scale was adhered to a photopolymeric light-sensitive planographic printing plate 11, and then a fixed exposure amount of light exposed and polymerized from above.

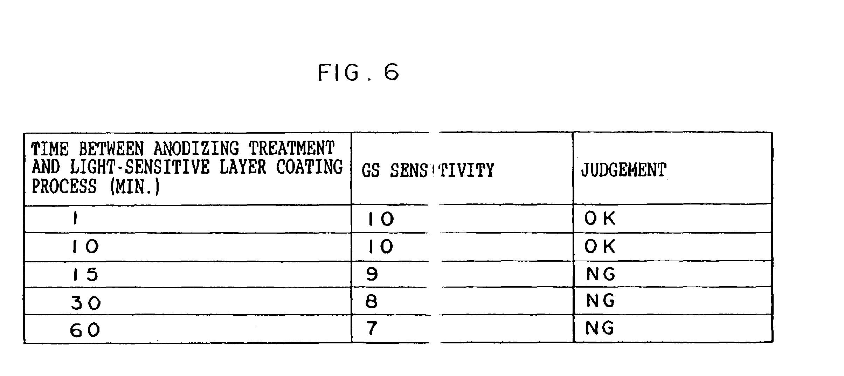

Thereafter, in an automatic processor (850NX, fabricated by Fuji Photo Film Co., Ltd.) the photopolymeric light-sensitive planographic printing plate 11 was immersed for 15 seconds at 30 °C in a solution of developer (DP-4, fabricated by Fuji Photo Film Co., Ltd. ) diluted to 18 times with water, at 1 litre of solution per 10 m². Here, GS sensitivity, which is shown in a table in Fig. 6, represents graduation levels at which, after the development treatment, an image portion will remain to the extent that the image portion can be distinguished from a non-image portion. A high graduation level of GS sensitivity means that sensitivity is high, and that, after the development treatment, a portion of the photopolymeric light-sensitive layer will remain, even if the amount of light exposure is small and the photopolymeric light-sensitive layer is not thoroughly polymerized. That is, it can be appreciated that the higher the graduation levels of the GS sensitivity, the higher the adhesion of the photopolymeric light-sensitive layer.

In view of cost reduction, in the present invention; an intermediate layer 18 to increase adhesion is not provided. However, with a view to controlling the coating amount of the absorption site, an undercoating process as described below may be provided prior to the main coating.

### Undercoating process

A sol composition is coated onto the surface of the aluminum support. The sol composition includes: (a) a compound containing a silane coupling agent having addition-polymerizable ethylene double bond, which compound has been hydrolyzed and dehydration-condensed, but is still in a sol state; (b) a compound which contains at least one alkylene oxide chain and at least one acryloyl or methacryloyl group in each molecule (which may be referred to as a "compound having an alkylene oxide chain"). The sol composition is then further hydrolyzed, dehydration-condensed, and cured and thereby gelled. Thus, an intermediate layer is provided on the aluminum support.

In the present invention, by observing that the absorption site of the AD layer has a strong absorbency, adhesion between the support and the photopolymeric light-sensitive layer can be improved. Further, use of an intermediate layer for increasing the adhesion becomes unnecessary and the photopolymerization light-sensitive planographic printing plate can be fabricated inexpensively.

## Claims

1. A method of fabricating a photopolymer type light-sensitive planographic printing plate comprising the steps of;
anodizing a support; and
coating the anodized support with a photopolymeric light-sensitive layer,
wherein adhesion controlled by controlling a time from completion of said anodizing treatment process to commencement of said photopolymeric light-sensitive layer coating process acts between the support and the photopolymeric light-sensitive layer.

2. A method according to claim 1, wherein the time from the completion of said anodizing treatment process to the commencement of said photopolymeric light-sensitive layer coating process is at most 10 minutes.

3. A method according to claim 1 that further comprising the steps of;
forming an absorption site at said support during said anodizing treatment process; and
coating the absorption site by silicate treatment process carried out prior to the photopolymeric light-sensitive layer coating process, wherein an amount of the coating of the absorption site is controlled.

4. A method according to claim 2 that further comprising the steps of;
forming an absorption site at said support during said anodizing treatment process; and
coating the absorption site by silicate treatment process carried out prior to the photopolymeric light-sensitive layer coating process, wherein an amount of the coating of the absorption site is controlled.

5. A method according to claim 3, wherein said coating is achieved by formation of a silicate film on said absorption site, and the amount of coating is controlled such that an Si elemental amount therein is from 0.1 mg/m² to 20 mg/m².

6. A method according to claim 4, wherein said coating is achieved by formation of a silicate film on said absorption site, and the amount of coating is controlled such that an Si elemental amount therein is from 0.1 mg/m² to 20 mg/m².
